# FASCICULE DE BREVET EUROPEEN

(11) **EP 2 144 075 B1**
(45) Date de publication et mention de la délivrance du brevet: **13.10.2010**
(21) Numéro de dépôt: 09354028.4
(22) Date de dépôt: 19.06.2009
(51) Int. Cl.: G01R 31/36

(54) **Procédé de détermination de l'état de charge d'une batterie en phase de charge ou de décharge à courant constant**
Verfahren zur Bestimmung des Ladezustands einer Batterie beim Aufladen oder Entladen mit konstantem Strom
Method for determining the level of charge in a battery being charged or uncharged with constant current

(30) Priorité: 10.07.2008 FR 0803939
(43) Date de publication de la demande: 13.01.2010
(73) Titulaire: Commissariat à l'Énergie Atomique et aux Énergies Alternatives, 75015 Paris (FR)
(72) Inventeur: Mingant, Rémy, 29870 Lannilis (FR); Martinet, Sébastien, 38000 Grenoble (FR); Lefrou, Christine, 38000 Grenoble (FR)
(74) Mandataire: Hecké, Gérard

(56) Documents cités:
- EP-A- 0 323 539
- EP-A- 1 391 742
- US-A1- 2002 036 504
- PILLER S ET AL: "Methods for state-of-charge determination and their applications" JOURNAL OF POWER SOURCES, ELSEVIER SA, CH, vol. 96, no. 1, 1 juin 2001 (2001-06-01), pages 113-120, XP004298736 ISSN: 0378-7753

## Description

### Domaine technique de l'invention

L'invention est relative à un procédé de détermination de l'état de charge d'une batterie, ayant une tension nominale prédéterminée, comportant une phase de charge ou de décharge de la batterie à courant constant.

### État de la technique

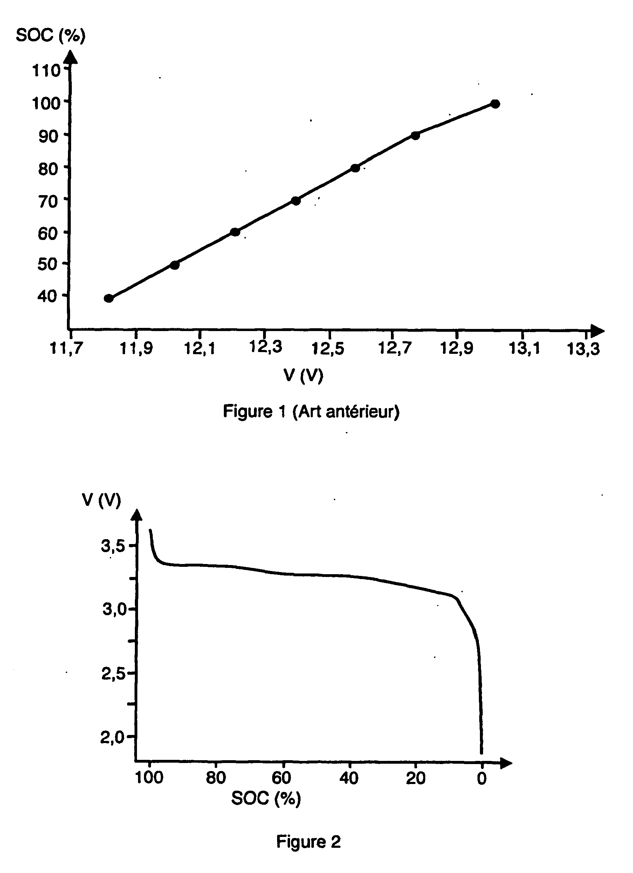

Dans les batteries au plomb, l'état de charge (SOC) varie, classiquement, en fonction de la tension de la batterie en circuit ouvert (courant nul) dans une large gamme, par exemple de plus de un Volt d'amplitude comme illustré à la figure 1 (article « Methods for state-of-charge determination and their applications » de Sabine Piller et al. publié en 2001 dans le « journal of power sources » pages 113 à 120). L'état de charge de ces batteries peut alors être déterminé par une simple interpolation de potentiel dont la précision dépend de la précision de la mesure de la tension ainsi que de la pente de la courbe de décharge de la batterie en fonction de son état de charge.

L'état de charge peut également être déterminé à partir de la mesure de la tension à courant non nul. La précision dépend alors de la précision de la mesure de tension, mais aussi du courant, de la pente de la courbe caractéristique de la décharge de la batterie en fonction de son état de charge, ainsi que des paramètres d'estimation de la tension de batterie à courant non nul.

Ces méthodes par interpolation du potentiel ne sont pas adaptées à certaines batteries actuelles, en particulier les batteries de type lithium-ion à cathode en matériau biphasique, dans lesquelles la différence de tension entre l'état chargé et l'état déchargé est faible, comme illustré à la figure 2.

De manière connue, l'état de charge d'une batterie peut également être déterminé par intégration du courant en fonction du temps. La précision d'une estimation utilisant cette méthode dépend de la précision de la mesure du courant. Il est également nécessaire de connaître la capacité initiale de l'élément, la capacité de charge totale, le rendement faradique. Un des principaux défauts de cette technologie est l'accumulation des erreurs cycles après cycles, induisant des incertitudes de plus en plus importantes (dépendantes des estimations de capacité initiales de l'élément et de sa capacité totale). Cette technique n'est donc pas applicable pour une gestion à long terme d'une batterie.

La demande de brevet européenne EP0323539 décrit une méthode de détermination de l'état de charge d'une batterie au Lithium. Cette méthode permet de déterminer l'état de charge de batteries dont les courbes de décharge sont relativement plates.

### Objet de l'invention

L'invention a pour but un procédé de détermination de l'état de charge précis ne présentant pas les inconvénients de l'art antérieur.

Ce but est atteint par le fait que le procédé comporte, au cours de ladite phase, les étapes successives suivantes :
- la mise en circuit ouvert de la batterie pendant une période de repos,
- l'application d'une tension de test, constante, aux bornes la batterie pendant une période de test prédéterminée,
- la mesure du courant à la fin de la période de test,
- la détermination de l'état de charge correspondant audit courant mesuré à la fin de la période de test au moyen d'une courbe d'étalonnage.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente une courbe de détermination de l'état de charge d'une batterie par l'intermédiaire d'une mesure de tension à circuit ouvert, selon l'art antérieur.
La figure 2 illustre la variation de la tension en circuit ouvert en fonction de l'état de charge d'une batterie lithium-ion.
La figure 3 représente l'évolution de la tension en fonction du taux de décharge de la batterie au cours d'une décharge à courant constant.
La figure 4 représente l'évolution de la tension de la batterie en fonction du temps pendant une phase de détermination de l'état de charge selon l'invention.
La figure 5 représente l'évolution du courant résultant en fonction du temps entre les instants t2 et t3 de la figure 4.
La figure 6 illustre une courbe d'étalonnage représentative du courant à la fin de la période de test en fonction de l'état de charge.

### Description de modes de réalisations particuliers

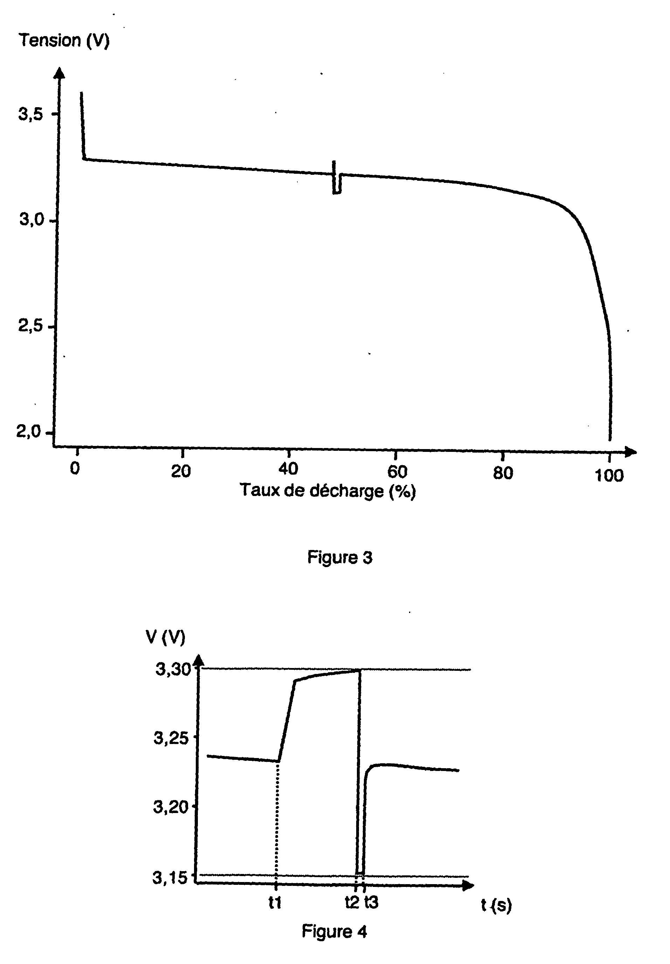

Comme illustré aux figures 3 à 5, pour déterminer l'état de charge de la batterie, de tension nominale prédéterminée, durant une phase de charge ou de décharge à courant constant, la batterie est tout d'abord mise au repos (à l'instant t1 sur la figure 4), c'est-à-dire que la batterie est placée en circuit ouvert et ne consomme plus de courant. Cette mise en période de repos provoque initialement une variation de la tension aux bornes de la batterie jusqu'à une tension de plateau correspondant à un état stable de la tension. Cette variation correspond à une augmentation de la tension si la batterie était en phase de décharge (figure 3 et 4) ou à une diminution de la tension si la batterie était en phase de charge. La période de repos (t1-t2) de la batterie est, de préférence, supérieure ou égale à 30s, de préférence d'une durée suffisante pour que la tension de plateau soit atteinte.

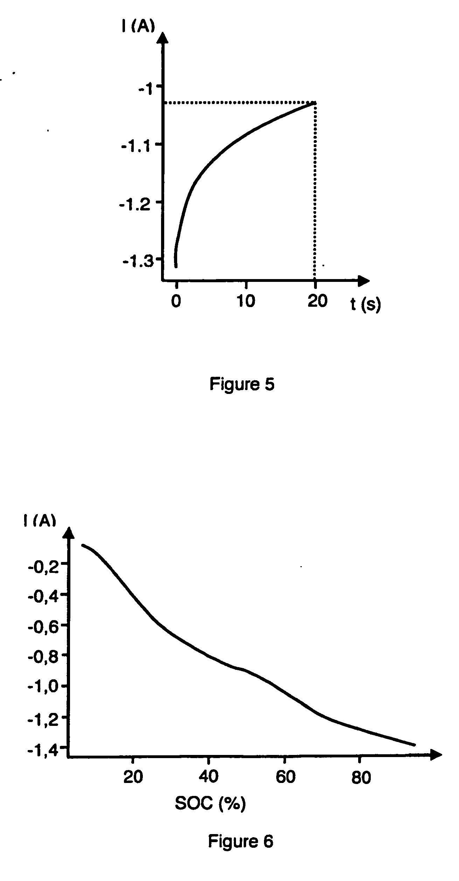

On applique ensuite (à l'instant t2 sur la figure 4) une tension de test, constante, aux bornes de la batterie pendant une période de test prédéterminée (t2-t3), de préférence inférieure ou égale à 30s. En effet, la période de test doit rester brève de manière à affecter le moins possible la valeur de l'état de charge à déterminer. Cette tension de test, constante, est inférieure à la tension nominale de la batterie si la détermination de l'état de charge est réalisée pendant une phase de décharge et supérieure à la tension nominale si la détermination est réalisée pendant une phase de charge. L'application d'une tension de test constante provoque une variation de courant 1 résultant dans la batterie. Comme illustré à la figure 5, qui correspond à une phase de décharge, le courant 1 augmente pendant la période de test. À la fin de la période de test, le courant 1 résultant est mesuré. Ce courant mesuré à la fin de la période de test est utilisé pour déterminer l'état de charge de la batterie à partir d'une courbe d'étalonnage obtenue au préalable à partir d'au moins une batterie étalon, et fournissant (figure 6) la relation entre le courant mesuré à la fin de la période de test

(déchargé ou chargé à tension constante) et l'état de charge de la batterie. Ainsi, la courbe d'étalonnage peut être établie, à partir d'au moins une batterie étalon, par mesure de la valeur du courant à la fin d'une période de test à tension constante, pour une pluralité de valeurs d'état de charge connues de la batterie étalon.

La courbe d'étalonnage, illustrée à la figure 6, a, par exemple, été obtenue à partir de deux éléments de batteries étalon, par mesure du courant à la fin de la période de test à tension constante, pour différents états de charge et avec plusieurs régimes de décharge. Une courbe d'étalonnage peut être obtenue, de manière analogue, pour la détermination de l'état de charge au cours d'une charge à courant constant. La reproductibilité de la mesure est fiable car l'écart type obtenu est inférieur à 5%.

À titre d'exemple, le procédé décrit ci-dessus a été utilisé pour une batterie de type LiFePO₄/LiC₆ d'une capacité de 1,4Ah, durant une phase de décharge de cette batterie à courant constant. La figure 3 représente l'évolution de la tension en fonction du taux de décharge pendant laquelle une détermination de l'état de charge est effectuée. La figure 4 illustre en détail le comportement de la tension de la batterie en fonction du temps pendant la phase de détermination de l'état de charge de la batterie. Ainsi, la période de repos (I=0) commence à un instant t1 et la durée de la période (t1-t2) de repos est de l'ordre de 600 secondes. La tension passe de 3,24V à l'instant t1 à une tension de plateau de 3,3V. A l'instant t2, la batterie est déchargée à une tension de décharge constante de 3,15 V pendant une période de test (t2-t3) d'une durée de 20s. Le courant I mesuré à l'instant t3 à la fin de la période de test, est de -1,03 A (figure 5). Le report de cette valeur sur la courbe d'étalonnage de la figure 6 permet de déterminer par simple lecture l'état de charge de la batterie correspondante, soit 60% dans l'exemple considéré.

À titre d'exemple, ce procédé peut également être utilisé pour déterminer l'état de charge d'une pile bouton de 1,3mAh, de type LifePO₄/Li₄Ti₅O₁₂ durant une décharge à courant constant. Après une période de repos (t1-t2) de 60s, une tension de test imposée de 1,84V a été appliquée pendant 30s. Le courant mesuré à la fin de la période de repos permet de déterminer l'état de charge de la pile à partir d'une courbe d'étalonnage correspondante.

La tension de test dépend, en particulier, en partie des propriétés des électrodes utilisées.

Les durées des périodes de repos et de test sont déterminées en fonction du type de batterie concernée. Par exemple, les batteries à recharge rapide comme les batteries à électrodes négative en Li₄TiO₁₂ nécessitent des durées plutôt courtes (par exemple, environ 30 secondes de repos et 1s de test). À l'inverse, les batteries à recharge plus lente comme les batteries à électrode négative en LiC₆ nécessitent des durées plus longues (600s de repos et 20 à 30 secondes de test).

La précision de la mesure (moins de 10% de la capacité totale) est meilleure que dans l'état de la technique.

Ce procédé particulièrement intéressant peut être appliqué dans le domaine photovoltaïque. Il peut aussi être appliqué dans le domaines des appareils mobiles, comme les téléphones et les ordinateurs ou encore dans le domaine des véhicules hybrides et électriques où il est critique d'utiliser des jauges de charge précises.

## Revendications

1. Procédé de détermination de l'état de charge d'une batterie, ayant une tension nominale prédéterminée, comportant une phase de charge ou de décharge de la batterie à courant constant, **caractérisé en ce qu'**il comporte, au cours de ladite phase, les étapes successives suivantes :
- la mise en circuit ouvert de la batterie pendant une période de repos (t1-t2),
- l'application d'une tension de test, constante, aux bornes la batterie pendant une période de test (t2-t3) prédéterminée,
- la mesure du courant à la fin de la période de test,
- la détermination de l'état de charge correspondant audit courant mesuré à la fin de la période de test au moyen d'une courbe d'étalonnage.

2. Procédé selon la revendication 1, **caractérisé en ce que** la batterie étant en phase de décharge, la tension de test est inférieure à la tension nominale de la batterie.

3. Procédé selon la revendication 1, **caractérisé en ce que** la batterie étant en phase de charge, la tension de test est supérieure à la tension nominale de la batterie.

4. Procédé selon l'une quelconque des revendications 1 à 3, **caractérisé en ce que** la durée de la période de repos (t1-t2) est supérieure ou égale à 30 secondes.

5. Procédé selon l'une quelconque des revendications 1 à 4, **caractérisé en ce que** la période de test est inférieure ou égale à 30 secondes.

6. Procédé selon l'une quelconque des revendications 1 à 5, **caractérisé en ce que** la courbe d'étalonnage est établie, à partir d'au moins une batterie étalon, par mesure de la valeur du courant à la fin d'une période de test à tension constante, pour une pluralité de valeurs d'état de charge connues de la batterie étalon.

## Claims

1. A method for determining the state of charge of a battery having a preset rated voltage, comprising a charging or discharging phase of the battery at constant current, **characterized in that** in the course of said phase, the method comprises the following successive steps:
- placing the battery in open circuit during a recovery period (t1-t2),
- applying a constant test voltage to the battery terminals during a preset test period (t2-t3),
- measuring the current at the end of the test period,
- determining the state of charge corresponding to said current measured at the end of the test period by means of a calibration curve.

2. The method according to claim 1, **characterized in that** the battery being in discharging phase, the test voltage is lower than the rated voltage of the battery.

3. The method according to claim 1, **characterized in that** the battery being in charging phase, the test voltage is greater than the rated voltage of the battery.

4. The method according to any one of claims 1 to 3, **characterized in that** the duration of the recovery period (t1-t2) is greater than or equal to 30 seconds.

5. The method according to any one of claims 1 to 4, **characterized in that** the test period is shorter than or equal to 30 seconds.

6. The method according to any one of claims 1 to 5, **characterized in that** the calibration curve is established, from at least one reference battery, by measuring the current value at the end of a test period at constant voltage for a plurality of known state-of-charge values of the reference battery.

## Patentansprüche

1. Verfahren zur Bestimmung des Ladestands einer Batterie mit einer vorbestimmten Nennspannung, das eine Lade- oder Entladephase der Batterie bei konstantem Strom umfasst, **dadurch gekennzeichnet, dass** es während der genannten Phase folgende aufeinanderfolgende Schritte umfasst:
- Schalten der Batterie in offenen Stromkreis während einer Ruheperiode (t1-t2),
- Anlegen einer konstanten Testspannung an die Klemmen der Batterie während einer vorbestimmten Testperiode (t2-t3),
- Messen des Stroms am Ende der Testperiode,
- Bestimmung des dem am Ende der Testperiode gemessenen Strom entsprechenden Ladestands mittels einer Eichkurve.

2. Verfahren nach Anspruch 1, **dadurch gekennzeichnet, dass** während der Entladephase der Batterie die Testspannung niedriger ist als die Nennspannung der Batterie.

3. Verfahren nach Anspruch 1, **dadurch gekennzeichnet, dass** während der Ladephase der Batterie die Testspannung höher ist als die Nennspannung der Batterie.

4. Verfahren nach einem der Ansprüche 1 bis 3, **dadurch gekennzeichnet, dass** die Dauer der Ruheperiode (t1-t2) länger als oder gleich 30 Sekunden ist.

5. Verfahren nach einem der Ansprüche 1 bis 4, **dadurch gekennzeichnet, dass** die Testperiode kürzer als oder gleich 30 Sekunden ist.

6. Verfahren nach einem der Ansprüche 1 bis 5, **dadurch gekennzeichnet, dass** die Eichkurve ausgehend von mindestens einer Vergleichsbatterie erstellt wird, und zwar durch Messen des Werts des Stroms am Ende einer Testperiode mit konstanter Spannung für eine Mehrzahl bekannter Ladestandswerte der Vergleichsbatterie.
